# EUROPEAN PATENT APPLICATION

(11) **EP 0 924 751 A2**
(43) Date of publication of application: **23.06.1999**
(21) Application number: 98310136.1
(22) Date of filing: 10.12.1998
(51) Int. Cl.: H01L 21/225, H01L 21/28

(54) **Well diffusion**

(30) Priority: 18.12.1997 US 68160 P
(71) Applicant: TEXAS INSTRUMENTS INC., Dallas, Texas 75243 (US)
(72) Inventor: Hattangady, Sunil V., McKinney, Texas 75070 (US); Kaya, Cetin (NMI), Dallas, Texas 75243 (US); Mercer, Douglas E., Richardson, Texas 75080 (US); Plumton, Donald L., Dallas, Texas 75229 (US)
(74) Representative: Potter, Julian Mark

(57) **Abstract**

A method of fabricating a semiconductor MOS device wherein a preferably doped semiconductor substrate, preferably silicon, is provided having a pad oxide, preferably silicon dioxide, on a surface thereof. A dopant of opposite conductivity type is disposed into the substrate, preferably by implantation through the pad oxide. The substrate is annealed at a temperature of from about 1150 to about 1200 degrees C in an ambient having from about 99.0 to about 99.9 percent by volume of a gas which is inert to the substrate during the annealing step and which is preferably nitrogen or argon and from about 1.0 to about 0.1 percent by volume oxygen and preferably about 0.25 percent by volume oxygen, to form the deep well in the substrate.

## Description

### BACKGROUND OF THE INVENTION

### FIELD OF THE INVENTION

This invention relates to fabrication of semiconductor devices and, more specifically but not exclusively, to the fabrication of gate structures for MOS semiconductor devices and tunnel oxides for semiconductor memory devices.

### BRIEF DESCRIPTION OF THE PRIOR ART

In the fabrication of MOS semiconductor devices having a deep well, the procedure generally begins with a substrate of doped semiconductor material, such as silicon, onto which is formed a sacrificial pad oxide, such as silicon dioxide. The deep well is then formed by implantation of a dopant of opposite conductivity type to the substrate into the substrate and through the pad oxide followed by a high temperature anneal at a temperature of about 1150 to about 1200°C for from about two to about three hours in a nitrogen ambient. The anneal causes the dopant to travel farther into the substrate to form the deep well. A result of this procedure is that some of the ambient nitrogen diffuses through the pad oxide at the elevated anneal temperatures and forms silicon nitride and/or silicon oxynitride within the pad oxide and, importantly, also forms a layer of silicon nitride at the interface of the substrate and the pad oxide. An etchant is then used to remove the sacrificial pad oxide by standard etching techniques prior to formation of the tunnel oxide. However, a problem arises in that the silicon nitride does not etch at the same rate as silicon dioxide with some of the silicon nitride remaining on the surface of the substrate after silicon dioxide removal. If this nitride layer is not consumed by extended sacrificial oxidation (>300 Angstroms), silicon surface roughening and shark tooth formation (oxide thinning at the active moat region or at the active moat/field oxide interface) are observed. This results in pitting on the surface of the substrate.

In an attempt to alleviate this problem, an inert ambient was substituted for the nitrogen ambient, specifically an argon ambient was used with the procedure otherwise being the same. Pitting and delamination were observed when annealing temperatures in the 1200°C range were encountered.

A still further attempt to overcome the above described problem involved the formation of a silicon nitride layer over the silicon dioxide pad oxide. This procedure, while providing the desired result, required not only the extra step of deposition of the silicon nitride layer, but also the use of two separate etching steps to remove both the silicon nitride layer and the silicon dioxide pad layer and was therefore economically unfeasible.

It is therefore apparent that the ability to economically perform very high temperature (about 1150 to 1200 degrees C) anneal for tank drive processes by avoiding un-intentional nitride formation that is detrimental to subsequent gate or tunnel oxide growth has still been sought in the art to provide shorter cycle time and higher throughput.

### SUMMARY OF THE INVENTION

In accordance with the present teaching, the above described problem of the prior art is reduced and there is provided an economically viable procedure for reducing the formation of silicon nitride at the interface of the substrate and the pad oxide.

Briefly, the above is accomplished by using, during the annealing step, a nitrogen and/or inert (e.g., a noble gas such as argon) ambient containing from about 0.1 to about 1.0 and preferably about 0.25 percent by volume oxygen therein, it being understood that the ambient generally will contain a minor and insignificant amount of impurities with reference to the procedures involved. This causes a small amount of silicon dioxide to be formed with the substrate silicon. The amount of oxygen in the ambient is such that the amount of silicon dioxide formation will be sufficiently small so as not to consume too much of the silicon and diminish the well size. However, since the oxygen is more reactive than is the nitrogen with silicon at the elevated annealing temperatures, oxide formation precedes nitride formation. This inhibits the formation of much nitride at the silicon/silicon dioxide interface, inhibits any tendency to delaminate, and provides the desired result as enumerated above.

The process in accordance with the present teaching is simple, uses existing equipment setups and requires merely a minor change to the presently existing process without additional processing steps. The process in accordance with the present teaching also inhibits nitridation of the silicon surface that leads to problems (surface pitting/roughening, non-uniform growth, delamination) with subsequent gate or tunnel oxide growth. In addition, the process in accordance with the present teaching forms thin, pristine sacrificial oxide which, when etched, leads to an improved gate or tunnel oxide.

### DESCRIPTION OF THE PREFERRED EMBODIMENT

A P-type doped silicon substrate was provided and a pad oxide having a thickness of 300 Angstroms was formed thereon by standard methods. Using standard lithographic techniques, the oxide was coated with photo-resist and patterned to reveal regions where a deep N-well was desired. Phosphorus was implanted through the oxide into the silicon in patterned regions at a dose of about 3 x 10¹³ cm⁻² and an energy of 500 keV. The photoresist was then subsequently removed. The substrate was then annealed at a temperature of 1200 degrees C for two hours in an ambient containing 99.75 percent by volume nitrogen and 0.25 percent by volume oxygen. The annealed substrate looked very clean and no defects were observed. The pad oxide thickening was 80 Angstroms.

The above described example was repeated except that the ambient contained 99.00 percent by volume nitrogen and 1.00 percent by volume oxygen. The annealed substrate looked very clean and no defects were observed. The pad oxide thickening was 250 Angstroms which can be excessive.

In each case, completion of a device will include standard steps of removing the pad oxide, forming a tunnel oxide and formation of gate, source and drain regions.

Though an aspect of the invention has been described with reference to a specific preferred embodiment thereof, many variations and modifications will immediately become apparent to those skilled in the art. It is therefore the intention that the appended claims be interpreted as broadly as possible in view of the prior art to include all such variations and modifications.

The scope of the present disclosure includes any novel feature or combination of features disclosed therein either explicitly or implicitly or any generalisation thereof irrespective of whether or not it relates to the claimed invention or mitigates any or all of the problems addressed by the present invention. The applicant hereby gives notice that new claims may be formulated to such features during the prosecution of this application or of any such further application derived therefrom. In particular, with reference to the appended claims, features from dependent claims may be combined with those of the independent claims and features from respective independent claims may be combined in any appropriate manner and not merely in the specific combinations enumerated in the claims.

## Claims

1. A method of fabricating a semiconductor device which comprises the steps of:
(a) providing a semiconductor substrate having a pad oxide on a surface thereof;
(b) disposing a dopant into said substrate; and
(c) then annealing said substrate in an ambient having from about 99.0 to about 99.9 percent by volume of a gas which is inert to said substrate during said step of annealing and substantially from about 1.0 to about 0.1 percent by volume oxygen.

2. The method of claim 1 wherein said substrate is doped a first conductivity type and said dopant is of opposite conductivity type.

3. The method of claim 1 or Claim 2 wherein said pad oxide is silicon dioxide and said substrate is silicon.

4. The method of any preceding claim wherein said step of annealing takes place at a temperature of from about 1150 to about 1200 degrees C.

5. The method of any preceding claim wherein said ambient contains about 99.75 percent by volume nitrogen and about 0.25 percent by volumen oxygen.

6. The method of any preceding claim for fabricating a semiconductor MOS device.

7. A method for fabricating a semiconductor device,comprising;
forming a semiconductor substrate having an oxide on a surface thereof;
disposing a dopant into said substrate, and annealing said substrate in an ambient environment comprising a volume of an inert gas and a volume of oxygen in a proportion to inhbit the formation of silicon nitride.

8. The method of any preceding claim wherein said dopant is disposed into said substrate by implanting said dopant through said pad oxide.

9. The method of any preceding claim wherein said gas is taken from the class consisting of nitrogen and argon.
